(19) Europäisches Patentamt
European Patent Office
Office européen des brevets

(11) **EP 1 532 851 B1**

(12) **EUROPÄISCHE PATENTSCHRIFT**

(45) Veröffentlichungstag und Bekanntmachung des Hinweises auf die Patenterteilung:
**08.03.2006 Patentblatt 2006/10**

(21) Anmeldenummer: **03790746.6**

(22) Anmeldetag: **25.08.2003**

(51) Int Cl.:
*H05K 3/12* (2006.01)     *H05K 1/09* (2006.01)
*H01L 51/10* (2006.01)     *H01L 51/40* (2006.01)

(86) Internationale Anmeldenummer:
**PCT/DE2003/002837**

(87) Internationale Veröffentlichungsnummer:
**WO 2004/021751 (11.03.2004 Gazette 2004/11)**

(54) **HERSTELLUNG ORGANISCHER ELEKTRONISCHER SCHALTKREISE DURCH KONTAKTDRUCKTECHNIKEN**

PRODUCTION OF ELECTRONIC ORGANIC CIRCUITS BY CONTACT PRINTING

PRODUCTION DE CIRCUITS DE COMMANDE ELECTRONIQUES ORGANIQUES PAR DES TECHNIQUES D'IMPRESSION PAR CONTACT

(84) Benannte Vertragsstaaten:
**DE FR GB IE IT NL**

(30) Priorität: **30.08.2002 DE 10240105**

(43) Veröffentlichungstag der Anmeldung:
**25.05.2005 Patentblatt 2005/21**

(73) Patentinhaber: **Infineon Technologies AG
81669 München (DE)**

(72) Erfinder:
• **ZSCHIESCHANG, Ute
91058 Erlangen (DE)**
• **HALIK, Marcus
91058 Erlangen (DE)**
• **KLAUK, Hagen
91058 Erlangen (DE)**
• **SCHMID, Günter
91334 Hemhofen (DE)**

(74) Vertreter: **Kottmann, Heinz Dieter
Patentanwälte,
Müller . Hoffmann & Partner,
Innere Wiener Strasse 17
81667 München (DE)**

(56) Entgegenhaltungen:
**EP-A- 0 402 942     WO-A-01/17319
WO-A-02/47183     DE-A- 10 126 859
US-A- 5 201 268     US-A- 5 362 513
US-A- 5 366 760**

• **ROGERS J A ET AL: "PRINTING PROCESS SUITABLE FOR REEL-TO-REEL PRODUCTION OF HIGH-PERFORMANCE ORGANIC TRANSISTORS AND CIRCUITS" ADVANCED MATERIALS, VCH VERLAGSGESELLSCHAFT, WEINHEIM, DE, Bd. 11, Nr. 9, 5. Juli 1999 (1999-07-05), Seiten 741-745, XP000851834 ISSN: 0935-9648**

**EP 1 532 851 B1**

**Beschreibung**

Die Erfindung betrifft ein Verfahren zur Herstellung einer organischen Leiterstrecke auf einem Substrat.

In der herkömmlichen Halbleitertechnologie auf der Basis anorganischer Halbleiter wird im Allgemeinen eine Zeitspanne von mehreren Monaten benötigt, um aus einem Schaltungsentwurf erste Muster der entsprechenden Chips herzustellen. Diese verhältnismäßig langen Zeiträume haben ihre Ursache in der Vielzahl von zum Teil recht aufwändigen Produktionsschritten, welche unterschiedlichste Verfahren wie Fotolithografie, Abscheidungsätzprozesse und dergleichen beinhalten, die bei der Herstellung des Mikrochips durchlaufen werden.

Für bestimmte Anwendungen bieten sich leitfähige organische Polymere langfristig als eine Alternative zu den bislang verwendeten anorganischen Halbleitermaterialien an. Organische Schichtsysteme lassen sich durch geeignete Drucktechniken relativ unkompliziert auf ein Substrat aufbringen. Im Gegensatz zu mikroelektronischen Bauelementen auf der Basis anorganischer Halbleiter lassen sich Strukturen aus organischen leitfähigen Materialien vergleichsweise kostengünstig herstellen.

Gleichwohl bleibt auch bei organischen Schichtsystemen die Aufgabe bestehen, das leitfähige Material entsprechend der zu erzielenden Schaltungslogik zu strukturieren. Werden Polymerschichten auf ein Substrat abgeschieden, gibt es prinzipiell die Möglichkeiten, entweder die Polymerschicht nach erfolgter Abscheidung zu strukturieren oder vor der Abscheidung einzelne Bereiche auf dem Substrat in gezielter Art und Weise zu definieren bzw. die Abscheidung des Polymeren auf das Substrat definiert zu steuern. Letztgenannte Möglichkeit bietet den Vorteil Materialkosten und aufwändige Reinigungs- oder Wiedergewinnungsprozesse einzusparen.

Soll die Polymerschicht erst nach der Abscheidung strukturiert werden, so können beispielsweise in das Polymer geeignete fotoaktive Komponenten eingebaut werden und auf diese Weise ein Polymer mit fotoaktiven Eigenschaften generiert werden. Durch selektive Belichtung kann dann z.B. die Löslichkeit des Polymers in einem Entwickler gezielt verändert werden.

Alternativ kann auch auf die Polymerschicht eine Fotolackschicht aufgebracht werden, welche zunächst mit Hilfe einer Fotomaske selektiv belichtet wird, um eine Strukturierung vorzubereiten. Nach der Entwicklung der Fotolackschicht wird eine Maske erhalten, und in einem nachfolgenden Ätzschritt, in den meisten Fällen ein Plasmaprozess, die freiliegenden Abschnitte des Polymers abgetragen. Abschließend muss noch die Fotomaske entfernt werden, z.B. mit einem geeigneten Lösungsmittel.

Ein erheblicher Nachteil dieses Verfahrens ist die Erfordernis eines sehr kostspieligen fotolithografischen Prozessschrittes. Neben hohen Material- und Gerätekosten für die Bereitstellung der Fotomasken, Fotomaskenbelichter, Fotolacke, Entwicklerlösungen und Lösungsmittel entstehen während der Fertigung zum Teil auch nur aufwändig zu entsorgende Sonderabfälle. Überdies erlaubt die Technik der Fotolithografie lediglich eine Strukturierung einer begrenzten Zahl von Substratelementen in einem einzigen Produktionszyklus, wobei entsprechende Ausfallzeiten für Vorbereitungs- und Nachbereitungsmaßnahmen ebenfalls-zu berücksichtigen sind, die zu einem niedrigen Prozessdurchsatz führen.

Neben optischen Verfahren zur selektiven Belichtung unter Verwendung von Fotomasken können auch mechanische Methoden zur Strukturierung eingesetzt werden. So bietet beispielsweise das Siebdruckverfahren die Möglichkeit, eine strukturierte Lackschicht auf das Polymer aufzubringen. Analog zu den optischen Verfahren erfordert diese Methode ebenfalls einen Strukturübertragungsprozess der Lackschicht auf das Substrat in einem Ätzprozess und die nachfolgende Entfernung des Lackes. Im Vergleich zu den optischen Verfahren liegt die erreichbare Strukturauflösung jedoch lediglich bei etwa 200 $\mu$m und kann deshalb nur für die Erzeugung von relativ groben Strukturen eingesetzt werden. Sie ist somit ausreichend für die Abbildung von großflächigen Leiterbahnen und Elektroden, muss jedoch bei feineren Strukturen, wie hochintegrierten Schaltkreisen durch höher auflösende Verfahren ersetzt werden.

Auch der Tintenstrahldruck ist ein mechanisches Verfahren zur Erzeugung definierter Strukturen in Polymerschichten. Das Polymer wird in diesem Fall als Lösung in Form kleiner Tröpfchen auf die Substratoberfläche aufgespritzt. Hierzu ist es erforderlich, dass das Polymer entweder selbst in einer druckfähigen Beschaffenheit vorliegt oder durch Beimischung geeigneter Lösungsmittel und Additive entsprechend präpariert wird. Die Zusatz- und Lösungsmittel sollten nach der Aufbringung rasch verdampfen, um ein Zusammenlaufen der Schichtstruktur zu verhindern.

Von Sirringhaus et al. ist ein Verfahren bekannt (Sirringhaus, H; Kawese, T; Friend, R. H.: High-Resolution Ink-Jet Printing of All-Polymer Transistor Circuits, in MRS Bulletin July 2001), bei dem zunächst mit einem Templat die zu bedruckenden Bereiche auf der Substratoberfläche festgelegt werden. Das Templat besteht aus feinen Polyimidstrukturen, welche von der Polymerdruckfarbe nicht benetzt werden und somit im nachfolgenden Tintenstrahldruck als Strukturgrundlage dienen.

Das Tintenstrahlverfahren weist jedoch eine Reihe von Nachteilen auf. Die Polyimidstrukturen müssen zunächst durch fotolithografische Verfahren strukturiert werden, wobei hohe Kosten anfallen. Ein Verzicht auf die Verwendung von Polyimidstrukturen führt hingegen durch das Zusammenlaufen der Druckstruktur zu einer Verringerung der Auflösung.

Als weiterer Nachteil erlaubt das Tintenstrahlverfahren nur einen zeilenweisen Strukturaufbau, wodurch eine niedrige Durchsatzrate und damit hohe Prozesskosten bedingt sind.

Während folglich die hohen Auflösungen fotolithografischer Strukturierungstechniken mit hohen Kosten verbunden sind, erlauben die vergleichsweise günstigen Siebdruck- oder Tintenstrahlverfahren nur eine geringe Auflösung.

Weitere Druckverfahren sind aus den Dokumenten US-A-5 201 268, WO 0 247 183 und WO 0 117 319 bekannt.

Aufgabe der Erfindung ist es daher, ein kostengünstiges Verfahren zur Strukturierung von Polymerfilmen aus elektrisch leitfähigen organischen Polymeren zur Verfügung zu stellen, welches eine hohe Auflösung auch kleiner Strukturen ermöglicht.

Diese Aufgabe wird gelöst durch ein Verfahren zur Herstellung einer organischen Leiterstrecke auf einem Substrat, welches zumindest die folgenden Schritte umfasst:

- Bereitstellen eines Substrates;

- Bereitstellen eines Druckstempels mit einer darauf befindlichen strukturierten Druckseite, wobei die strukturierte Druckseite erhabene Abschnitte und zwischen den erhabenen Abschnitten angeordnete tiefer liegende Abschnitte aufweist, welche einer abzubildenden Struktur entsprechen;

- Beladen der strukturierten Druckseite mit einer Drucklösung, die zumindest ein leitfähiges organisches Polymer oder eine Vorstufe eines solchen Polymers enthält;

- gegebenenfalls Entfernen überschüssiger Drucklösung von den erhabenen Abschnitten der strukturierten Druckseite, so dass die Drucklösung nur in den tiefer liegenden Abschnitten der strukturierten Druckseite verbleibt;

- gegenseitiges Anordnen und Justieren von Substrat und Druckstempel zueinander, wobei das Substrat auf der strukturierten Druckseite angeordnet wird und in Kontakt bringen der strukturierten Druckseite mit dem Substrat;

- Entfernen des Druckstempels vom Substrat und Übertragen der in der strukturierten Druckseite befindlichen Drucklösung auf das Substrat.

Das erfindungsgemäße Verfahren stellt ein sehr einfaches und kostengünstiges Verfahren zur Erzeugung von Strukturen aus einem leitfähigem Polymer auf einem Substrat bereit. Im Gegensatz zu zeit- und kostenintensiven fotolithografischen Verfahren, fallen während des Verfahrens kaum Rückstände an verwendeten Materialien und Chemikalien an. Eine komplexe Vorbereitung von Substrat, Fotolack, Belichtungsmaske und Belichtungsapparatur ist nicht notwendig und das Verfahren kann bei entsprechender Geometrie von Substrat und Druckstempel auch kontinuierlich durchgeführt werden, so dass hohe Umsätze bei niedrigem Kostenaufwand erreicht werden können.

Auch die zu erreichende Auflösung ist für Anwendungen im mikroelektronischen Bereich für ein auf mechanischen Prozessen beruhendes Verfahren äußerst zufriedenstellend und übertrifft die Auflösung, die mit vergleichbaren mechanischen Verfahren, wie Tintenstrahl- oder Siebdruck erreicht werden können deutlich.

In einer vorteilhaften Ausführungsform des erfindungsgemäßen Verfahrens wird die auf das Substrat übertragene Drucklösung durch einen Bakeschritt fixiert. Durch die erhöhte Temperatur während des Bakeschrittes können Lösungsmittelreste verdampfen, so dass lediglich die in der Drucklösung gelösten Bestandteile verbleiben und die aus diesen Bestandteilen bestehende gewünschte Struktur verfestigt und auf dem Substrat fixiert wird. Das Entfernen von Lösungsmittel erhöht darüber hinaus, insbesondere zu Beginn der Lösungsmittelverdampfung, die Viskosität der Drucklösung, wodurch ein Zusammenlaufen der Lösung nach dem Druckprozess verhindert und die abgebildete Struktur unmittelbar nach dem Aufbringen stabilisiert wird.

Es ist vorteilhaft, wenn die strukturierte Druckseite eine hydrophobe und das Substrat eine hydrophile Grenzfläche aufweisen. Die gegensätzlichen Grenzflächeneigenschaften von strukturierter Druckseite und Substrat erleichtern eine Ablösung der Drucklösung aus der strukturierten Druckseite und deren Übertragung auf die Substratoberfläche. Dadurch wird gewährleistet, dass die Übertragung der Drucklösung von der strukturierten Druckseite auf das Substrat weitgehend vollständig erfolgt. Es verbleiben keine Reste der Drucklösung in den tiefer liegenden Abschnitten des Druckstempels, die eine fehlerhafte Strukturabbildung verursachen können. Gleichzeitig wird bei gegensätzlichen Grenzflächeneigenschaften die Geschwindigkeit der Übertragung der Drucklösung optimiert, so dass ein höherer Umsatz an gebildeten Strukturen erreicht werden kann.

Der Kontrast der Grenzflächeneigenschaften zwischen strukturierter Druckseite (hydrophob) und Substrat (hydrophil) kann dadurch erreicht werden, dass der strukturierte Druckstempel aus einem hydrophoben Material (z.B. hydrophobe Polymere wie Polybenzoxazole, Polyimide, Novolacke etc.) und das Substrat aus einem oxidischen Material (z.B. Glas oder Keramik) oder einem Metall (z.B. Kupfer oder Nickel) gefertigt ist.

Daneben eignen sich für die Herstellung des Substrates auch Polymere, die Hydroxygruppen enthalten (z.B. Polyvinylpyrrolidon), oder auch Polymere, die nachträglich mit Hydroxygruppen funktionalisiert werden, beispielsweise durch eine Behandlung im Sauerstoffplasma.

Es ist besonders vorteilhaft, wenn die Drucklösung hydrophil ist. Durch ähnliche Grenzflächeneigenschaften von Substrat und Drucklösung (in diesem Fall eine Hydrophilie) wird die Anhaftung der Drucklösung auf das Substrat erleichtert. Die vergleichbare Wechselwirkung zwischen den Molekülen der Drucklösung und den Molekülen der Substratoberfläche im Vergleich zu den Wechselwirkungen zwischen Substratmolekülen und Drucklösungsmolekülen untereinander bewirkt ferner eine Stabilisierung der aufgedruckten Struktur, da ein Auseinanderlaufen und damit eine Zerstörung der Druckstruktur weitgehend vermieden wird. Zudem wird die Ablösung der Drucklösung aus der strukturierten Druckseite durch die gegensätzlichen Grenzflächeneigenschaften erleichtert und dem Verbleib der Drucklösung in den Vertiefungen der strukturierten Druckform durch die vorhandenen Kapillarkräfte entgegengewirkt. Ferner resultiert aus einer Hydrophilie der Drucklösung eine große Oberflächenspannung gegenüber Luft (hydrophob), wodurch die auf das Substrat aufgebrachte Drucklösung in ihrer Struktur durch Ausbilden eines großen Randwinkels an den Randbereichen der Struktur stabilisiert wird. Neben Drucklösungen können auch Drucksuspensionen verwendet werden. Bei Verwendung einer Drucksuspension ist auf eine möglichst homogenen Verteilung und Dispersion der suspendierten Teilchen (z.B. organische leitfähige Polymere als Träger elektrischer Leitfähigkeit) in dem Dispersionsmittel zu achten, damit eine gleichmäßige Verteilung der Teilchen in der erzeugten Struktur und damit ein reproduzierbares Verhalten einer evtl. gebildeten elektronischen Schaltkreisstruktur erreicht wird.

In einer vorteilhaften Ausführungsform des erfindungsgemäßen Verfahrens werden die hydrophobe Grenzfläche der strukturierten Druckseite bzw. die hydrophile Grenzfläche des Substrates durch eine Grenzflächenbehandlung erzeugt. Durch eine Grenzflächenbehandlung erweitert sich die Anzahl an Materialien, die für das erfindungsgemäße Verfahren verwendet werden können, da die Grenzfläche weitgehend unabhängig von den Bulkeigenschaften modifiziert werden kann. Häufig lassen sich durch entsprechende Behandlungen die Grenzflächeneigenschaften besser optimieren, (d.h. beispielsweise auf einen bestimmten Oberflächenspannungswert einstellen) als dies nur durch eine reine Materialauswahl möglich wäre.

Auf diese Weise kann bei Bedarf auch eine Umkehrung der Grenzflächeneigenschaften von hydrophil zu hydrophob und umgekehrt erreicht werden. So lässt sich eine Hydrophilisierung beispielsweise durch eine oxidative Behandlung unter Einführung von Hydroxylgruppen, Amingruppen oder Thiolgruppen erreichen, während eine Hydrophobierung einer hydrophilen Oberfläche unter Verwendung der reaktiven Oberflächenatome durch Anbinden monofunktioneller Verbindungen mit hydrophoben Alkylresten erreicht werden kann. Dabei kann die Oberflächenbehandlung zur Erhöhung des hydrophil/hydrophob-Kontrastes durch Aufbringen einer verdünnten Lösung des entsprechenden Hydrophobisierungsreagenzes und Verdampfen des Lösungsmittels oder aus der Gasphase erfolgen. Hierdurch eröffnet sich die Möglichkeit hydrophile ursprünglich als Substrate zu verwendende Materialien auch als Werkstoffe für den mit einer hydrophoben Druckseite versehenen Druckstempel zu verwenden und umgekehrt.

Der Druckstempel weist bevorzugt eine zylinderförmige Geometrie auf, wobei die strukturierte Druckseite auf dessen Umfangsfläche angeordnet ist. Auf diese Weise kann ein kontinuierliches Verfahren realisiert werden, wobei der Druckstempel in Form einer Rolle, Walze oder Trommel mit dem Substrat in Kontakt gebracht wird. Kontinuierliche Verfahren haben den Vorteil, schnellere Produktionszyklen zu ermöglichen, da die bei unstetigen Verfahren auftretenden Totzeiten, die zur Vorbereitung eines nachfolgenden Produktionszyklus dienen, entfallen. Dadurch wird die Umsatzrate erhöht und eine bessere Produktionsauslastung erreicht, wodurch insgesamt die Herstellungskosten verringert werden können.

Es ist vorteilhaft, wenn die strukturierte Druckseite und/oder der Druckstempel aus einem flexiblen Material bestehen. Flexible Materialien erlauben eine bessere Kontaktierung von Druckstempel und Substrat, da Unregelmäßigkeiten der beteiligten Oberflächen (z.B. Unebenheiten oder eingebrachte verunreinigende Partikel) bei entsprechendem Anpressdruck ausgeglichen werden. Dadurch wird die Qualität der Strukturübertragung verbessert und die Fehlerquote verringert.

Es ist besonders vorteilhaft, wenn das Substrat aus einem flexiblen Material besteht. Neben der bereits erwähnten vorteilhaften Auswirkung auf die Druckqualität kann bei flexiblen Substratmaterialien ein kontinuierliches Verfahren verwirklicht werden, beispielsweise durch Verwendung einer Substratfolie, die stetig mit einem als Walze ausgeformten Druckstempel in Kontakt gebracht wird.

In einer bevorzugten Ausführungsform des erfindungsgemäßen Verfahrens ist eine Andruckrolle vorgesehen, mit welcher das aus einem flexiblen Material bestehende Substrat auf die strukturierte Druckseite gedrückt wird. Damit kann in einem kontinuierlichen Verfahren das flexible Substrat mit einem ausreichend hohen Anpressdruck auf die strukturierte Druckseite gepresst werden, wodurch die Übertragungsqualität verbessert wird.

Es ist vorteilhaft, wenn das Verfahren mehrmals mit gleichen oder verschiedenen Druckseiten mit jeweils gleichen oder verschiedenen Drucklösungen auf das gleiche Substrat angewandt wird. Insbesondere bei hochkomplexen elektronischen Schaltkreisen liegt eine komplexe dreidimensional strukturierte Anordnung von Schaltkreisen vor, welche formal aus einer Übereinanderstapelung von zweidimensionalen Schaltkreisebenen gebildet wird. Dabei ist auch eine Variation der Leitfähigkeit der eingesetzten Materialien erforderlich, um verschiedenste elektronische Bauelemente verwirklichen zu können. Durch eine wiederholte Anwendung des erfindungsgemäßen Verfahrens mit unterschiedlichen Drucklösungen und Strukturen lassen sich derartig komplexe Systeme herstellen.

Bevorzugt wird die Leiterstrecke zu einem mikroelektronischen Bauelement ergänzt. Möglicherweise müssen nur Teilbereiche eines mikroelektronischen Bauelementes mithilfe des erfindungsgemäßen Verfahrens hergestellt werden, während der restliche Anteil durch herkömmliche Verfahren gefertigt werden kann. Dadurch ergibt sich eine hohe Flexibilität bei der Auswahl möglicher zu realisierender Bauelemente unter Wahrung wirtschaftlicher Aspekte, da die einzelnen Verfahren unterschiedliche Kosten erfordern können.

Besonders bevorzugt ist das mikroelektronische Bauelement ein Feldeffekttransistor. Feldeffekttransistoren sind aufgrund ihrer vielfältigen Verwendungsmöglichkeiten in der Mikroelektronik häufig verwendete Bauelemente, die aus verschiedenen Strukturebenen bestehen und mit dem erfindungsgemäßen Verfahren in einem Mehrstufenverfahren kostengünstig hergestellt werden können.

Die Erfindung wird unter Bezugnahme auf die beigefügten Figuren sowie anhand von Beispielen näher erläutert. Die Figuren zeigen im einzelnen:

Fig. 1    eine schematische Darstellung des Ablaufs eines Druckvorgangs

Fig. 2    eine schematische Darstellung einer Verstärkung des hydrophil/hydrophoben Kontrastes durch Aufbringen einer hydrophoben Silanschicht

Fig. 3    eine schematische Darstellung des Druckvorgangs in einem kontinuierlichen Verfahren mit einer Rollentechnik

Fig. 4    eine Kennlinienschar eines nach Beispiel 17 hergestellten organischen Transistors (Breite 40 $\mu$m, Länge 100 $\mu$m)

Fig. 5    eine Kennlinienschar eines nach Beispiel 18 hergestellten organischen Transistors (Breite 20 $\mu$m, Länge 100 $\mu$m)

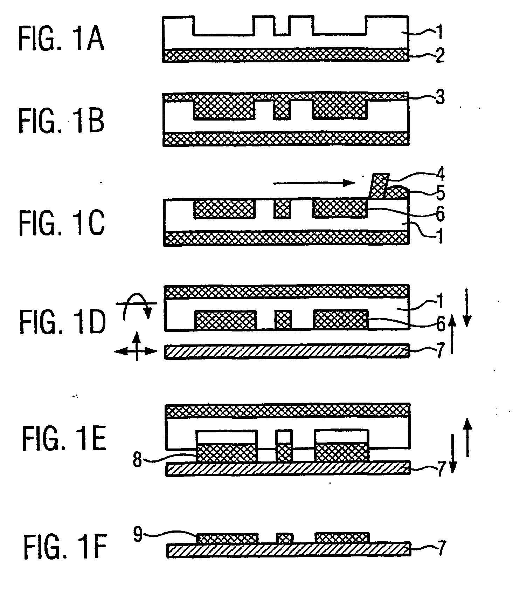

Fig. 1 zeigt die einzelnen Schritte während des zeitlichen Ablaufs eines Druckvorganges. Zunächst wird wie in Fig. 1a gezeigt, ein Druckstempel bestehend aus einem Trägersubstrat 2 und einer auf dem Trägersubstrat 2 angeordneten strukturierten Druckseite 1, welche ein Strukturprofil in Form einer Positivstruktur enthält, bereitgestellt.

Im nachfolgenden in Fig. 1b gezeigten Schritt wird die strukturierte Druckseite 1 mit einer Polymerlösung 3 oder einer Polymersuspension, die das leitfähige Polymer enthält, beladen, wobei insbesondere die tieferliegenden Abschnitte der strukturierten Druckseite 1 ausreichend mit der Drucklösung oder -suspension 3 bedeckt werden. Es ist dabei zunächst unerheblich, ob auch die erhabenen Abschnitte der strukturierten Druckseite 1 mit der Drucklösung/-suspension 3 in Kontakt kommen.

Die auf den erhabenen Abschnitten der strukturierten Druckseite 1 befindliche überschüssige Drucklösung/-suspension 5 wird, wie in Fig. 1c gezeigt, durch mechanisches Abstreifen mit Hilfe einer Rakelvorrichtung 4 entfernt, so dass ein definiertes Volumen an Drucklösung/-suspension 6 lediglich in den tieferliegenden Abschnitten der strukturierten Druckseite 1 verbleibt.

Anschließend wird, wie in Fig. 1d gezeigt, der Druckstempel gedreht, wobei die Drucklösung/-suspension 6 aufgrund der Adhäsions- und Kapillarwechselwirkung in der Struktur der strukturierten Druckseite 1 verbleibt, und über einem Substrat 7 geeignet justiert. Durch Absenken des Druckstempels und/oder Anheben des Substrates 7 wird die strukturierte Druckseite 1 mit dem Substrat 7 in Kontakt gebracht.

Nachfolgend erfolgt, wie in Fig. 1e gezeigt, durch Anheben des Druckstempels und/oder Absenken des Substrates 7 ein Ablösen der strukturierten Druckseite 1 vom Substrat 7 unter Hinterlassen der Drucklösung-/suspension 8 mit einer definierten Schichtstruktur auf dem Substrat 7. Dabei kann aufgrund der Oberflächenspannung eine geringe Menge an organischem leitfähigen Polymer in den tiefliegenden Abschnitten der strukturierten Druckseite 1 verbleiben.

Schließlich wird mit einem Bakeschritt das Lösungsmittel verdampft und die Struktur als verfestigte Schichtstruktur 9 auf dem Substrat 7 fixiert (Fig. 1f).

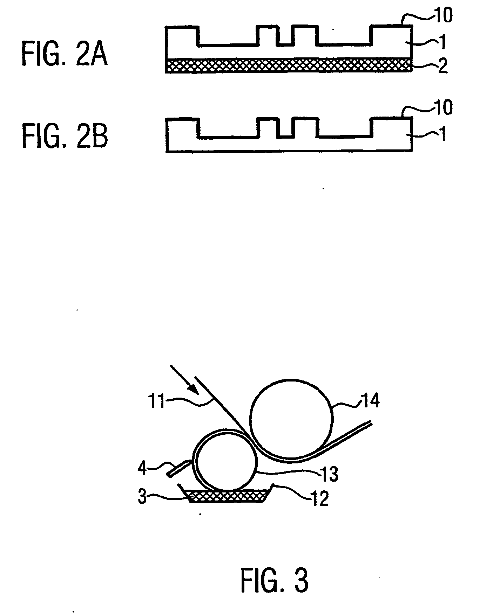

Fig. 2a zeigt eine hydrophobierte strukturierte Druckseite 1 auf einem Trägersubstrat 2 zur Erhöhung des hydrophil/hydrophob-Kontrastes. Eine hydrophobe Silanschicht 10 ist dabei lückenlos auf den tieferliegenden und erhabenen Abschnitten der strukturierten Druckseite 1 aufgetragen. Die strukturierte Druckseite 1 kann sich dabei auf einem Trägersubstrat 2 befinden, wie in Fig. 2a gezeigt oder isoliert vorliegen, wie in Fig. 2b gezeigt.

In Fig. 3 ist in einer schematischen Darstellung gezeigt, wie die Erfindung in einem kontinuierlichen Verfahren durchgeführt werden kann. Als Druckstempel wirkt eine rotierende Walze 13, auf deren Umfangsfläche eine strukturierte Druckseite (nicht gezeigt) angeordnet ist. Ein bestimmter Bereich der Walze taucht dabei in eine Reservoirwanne 12 ein, welche die Drucklösung-/suspension 3 enthält, so dass der eintauchende Bereich mit der Drucklösung-/suspension 3 beladen wird. Eine Rakelvorrichtung 4, welche die erhabenen Abschnitte der strukturierten Druckseite knapp berührt, streift überschüssige Drucklösung-/suspension 3 von den erhabenen Abschnitten der strukturierten Druckseite ab, die in die Wanne zurückfließt. Als Substrat dient eine flexible Folie 11, welche mit Hilfe einer rotierenden Andruckrolle 14 auf die Umfangsfläche der rotierenden Walze 13 angedrückt wird. Durch die gegenläufige Rotationsrichtung von Walze 13 und Andruckrolle 14 wird die Substratfolie 11 zwischen diesen beiden Rollen hindurchgeführt und übernimmt bei der Kontaktierung mit der auf der Umfangsfläche der rotierenden Walze 13 angeordneten strukturierten Druckseite die in den tieferliegenden Abschnitten der strukturierten Druckseite befindliche Drucklösung-/suspension 3 in Form des gewünschten Strukturprofils. Durch eine stetige Nachlieferung an Substratfolie 11 und Nachliefern von Drucklösung-/suspension 3 aus der Reservoirwanne 12 kann das Verfahren kontinuierlich durchgeführt werden.

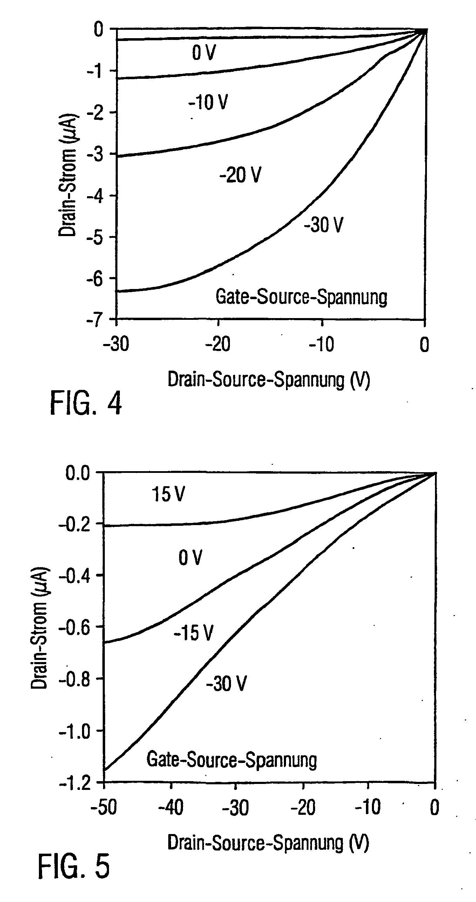

Fig. 4 zeigt die Kennlinienschar eines nach Beispiel 17 hergestellten organischen Transistors, wobei die Stromstärke am Drainkontakt (Drain-Strom, in $\mu$A) gegen die angelegte Spannung zwischen Drain- und Source-Kontakt (Drain-Source-Spannung, in V) aufgetragen ist. Scharparameter ist die zwischen Gate- und Sourceelektrode angelegte Spannung (Gate-Source-Spannung). Der hergestellte organische Transistor weist dabei eine Breite von 40 $\mu$m und eine Länge von 100 $\mu$m auf.

Es ist eine deutliche Zunahme des Drain-Stromes mit steigender Drain-Source-Spannung zu erkennen. Diese Abhängigkeit wächst mit steigender Gate-Source-Spannung.

Fig. 5 zeigt die Kennlinienschar eines nach Beispiel 18 hergestellten organischen Transistors, wobei die Stromstärke am Drainkontakt (Drain-Strom, in $\mu$A) gegen die angelegte Spannung zwischen Drain- und Source-Kontakt (Drain-Source-Spannung, in V) aufgetragen ist. Scharparameter ist die zwischen Gate- und Sourceelektrode angelegte Spannung (Gate-Source-Spannung). Der hergestellte organische Transistor weist dabei eine Breite von 20 $\mu$m und eine Länge von 100 $\mu$m auf.

Auch bei diesem Beispiel ist eine deutliche Zunahme des Drain-Stromes mit steigender Drain-Source-Spannung zu erkennen. Diese Abhängigkeit wächst mit steigender Gate-Source-Spannung.

Im Vergleich der Fig. 4 und 5 wird deutlich, dass die Abhängigkeit zwischen Drain-Strom und Drain-Source-Spannung bei gleicher Gate-Source-Spannung mit abnehmender Breite des Transistors zunimmt, wie es für einen Feldeffekttransistor charakteristisch ist.

Ein mit dem erfindungsgemäßen Verfahren hergestellter organischer Feldeffekttransistor weist somit die gleichen Merkmale wie ein herkömmlicher aus einem organischen Halbleiter gefertigter Feldeffekttransistor auf.

Die Ausführung des erfindungsgemäßen Verfahrens wird in den folgenden Beispielen demonstriert.

Beispiel 1

Herstellung einer planaren Masterplatte (Fotolack)

Durch Spincoating wird auf einen runden 4-Zoll-Glaswafer, der als Druckstempel dient, eine 1,3 $\mu$m dicke Schicht eines Positiv-Fotolacks aufgetragen. Zur Verdampfung des Lösungsmittels wird der Fotolack für 1 Minute bei 100°C getrocknet. Anschließend werden die zu übertragenden Strukturen durch Belichtung über eine Dunkelfeldmaske abgebildet. Das latente Bild der Strukturen wird unter Ausbildung erhabener und tiefer liegender Abschnitte entwickelt und die Glasscheibe im Vakuum zur Vertreibung der Lösungsmittel getrocknet. Die tiefer liegenden Abschnitte der entwickelten Strukturen bilden das Reservoir für die zu übertragende Polymersuspension mit einer Tiefe von 1,3 $\mu$m.

Beispiel 2

Herstellung eines planaren Druckstempels aus Polybenzoxazol

Auf einen runden als Druckstempel dienenden 4-Zoll-Glaswafer wird eine Schicht eines Poly-o-hydroxyamins (20 Gew.-% in NMP) als hydrophiles Material durch Spincoating aufgebracht. Das Poly-o-hydroxyamin kann aus Isophthalsäuredichlorid und 3,3'-Dihydroxybenzidin 1:1 (Polybenzoxazolvorstufe) synthetisiert werden. Anschließend erfolgt ein Bakeschritt von 2 Minuten bei 120°C zur Verdampfung der Lösungsmittel und ein Temperschritt von 2 Stunden bei 400°C zur Zyklisierung zum Polybenzoxazol (PBO).

Auf die erhaltene Polybenzoxazol-Schicht wird eine Schicht eines Positivfotolackes durch Spincoating aufgebracht. Der Fotolack wird für 1 Minute bei 100°C getrocknet und anschließend durch eine Dunkelfeldmaske, welche die zu übertragenden Strukturen abbildet, belichtet. Die Strukturen werden zur Ausbildung der strukturierten Druckseite entwickelt und bei 100°C getrocknet. Es verbleiben Fotolackstrukturen, welche die Ätzmaske für den folgenden Ätzschritt des Polybenzoxazols bilden. Mit einem Sauerstoffplasma wird das Polybenzoxazol geätzt und das Strukturprofil übertragen.

Anschließend wird der verbliebene Fotolack mit Aceton entfernt, dann das Glassubstrat mit Wasser gespült und getrocknet. Die Schichtdicken der Polybenzoxazol-Schicht und somit die Tiefe des Reservoirs können über die Schleudergeschwindigkeit und Formulierung des Poly-o-hydroxyamins eingestellt werden.

Beispiel 2a

$$\text{Drehzahl } 2000 \text{ rpm } (30 \text{ s}) = 2,5 \text{ µm}$$

Beispiel 2b

$$\text{Drehzahl } 3000 \text{ rpm } (30 \text{ s}) = 1,8 \text{ µm}$$

Beispiel 2c

$$\text{Drehzahl } 4000 \text{ rpm } (30 \text{ s}) = 1,3 \text{ µm}$$

Beispiel 3

Herstellung einer planaren Druckstempels aus Polyimid

Mittels Spincoating wird auf ein rundes als Druckstempel dienendes 4-Zoll-Glassubstrat eine Schicht von Poly-(biphenyl-3,3'-4,4'-tetracarbonsäuredianhydrid-co-1,4-phenylindiamin) (10 Gew.-% in NMP) aufgebracht. Über einen nachfolgenden Bakeschritt von 10 Minuten bei 120°C zur Verdampfung von Lösungsmitteln und einen zweistündigen Temperschritt bei 400°C erfolgt die Zyklisierung zum Polyimid (PI). Auf die Polyimid-Schicht wird eine Schicht eines Positivfotolackes durch Spincoating aufgebracht. Der Fotolack wird 1 Minute bei 100°C getrocknet und anschließend durch eine Dunkelfeldmaske, welche die zu übertragenden Strukturen abbildet, belichtet. Die Strukturen werden entwickelt und bei 100°C getrocknet. Die verbleibenden Fotolackstrukturen bilden die Ätzmaske für den folgenden Ätzschritt des Polyimids. Das Ätzen des Polyimids erfolgt mittels Sauerstoffplasma, wodurch es zur Ausbildung des Strukturprofils kommt. Schließlich wird der verbliebene Fotolack mit Aceton entfernt und das Glassubstrat mit Wasser gespült und getrocknet. Die Schichtdicken der Polyimid-Schicht und somit die Tiefe des Reservoirs können über Variation der Schleudergeschwindigkeit eingestellt werden.

Beispiel 3a

$$\text{Drehzahl } 2000 \text{ rpm } (30 \text{ s}) = 1,9 \text{ µm}$$

Beispiel 3b

$$\text{Drehzahl } 3000 \text{ rpm } (30 \text{ s}) = 1,4 \text{ µm}$$

Beispiel 3c

$$\text{Drehzahl 4000 rpm (30 s) = 1,1 } \mu\text{m}$$

Beispiel 4

Herstellung eines flexiblen Druckstempels mittels eines Fotolackes

Durch Spincoating wird auf eine Polyethylennaphthalatfolie (PEN) eine 1,3 $\mu$m dicke Schicht eines Positivfotolackes aufgebracht. Zur Verdampfung des Lösungsmittels wird der Positivfotolack für 1 Minute bei 100°C getrocknet und anschließend durch eine Dunkelfeldmaske, welche die zu übertragenden Strukturen abbildet, belichtet. Zur Ausprägung des Strukturprofils bestehend aus erhabenen und tieferliegenden Abschnitten werden die Strukturen entwickelt und die hydrophobe Polyethylennaphthalat-Folie im Vakuum gut getrocknet. Die entwickelten Strukturen bilden das Reservoir für die zu übertragende Polymersuspension mit einer Tiefe von 1,3. $\mu$m. Schließlich wird die Polyethylennaphthalat-Folie auf einen runden Kunststoffzylinder, der als Druckstempel dient, geklebt.

Beispiel 5

Herstellung eines flexiblen Druckstempels aus Polyimid

Durch Spincoating wird auf eine Polyimid-Folie (Kapton®) eine Schicht eines Positivfotolackes aufgebracht. Zur Entfernung von Lösungsmitteln wird der Fotolack für 1 Minute bei 100°C getrocknet und anschließend durch eine Dunkelfeldmaske, welche die zu übertragenden Strukturen abbildet, belichtet. Die Strukturen werden entwickelt und bei 100°C getrocknet. Die verbleibenden Fotolackstrukturen bilden die Ätzmaske für den folgenden Ätzschritt des Polyimids. Das Ätzen des Polyimids erfolgt mittels Sauerstoffplasma, wodurch das Strukturprofil ausgeprägt wird. Über eine Variation der Ätzzeit sowie der Ätzrate kann die Tiefe der Reservoirstruktur bestimmt werden. Im nachfolgenden Schritt wird der verbliebene Fotolack mit Aceton entfernt. Die hydrophobe Polimid-Folie wird anschließend auf einen runden Kunststoffzylinder, der als Druckstempel dient, geklebt.

Beispiel 6

Hydrophobe Beschichtung eines Druckstempels

Die in den oben angeführten Beispielen 1 bis 5 beschriebenen Druckstempel werden in einem Vakuumofen bei einer Temperatur von 100°C und einem Druck von 200 mbar mit Octadecyltrichlorosilan (OTS) bedampft. Durch die Octadecylgruppe werden hydrophobe Eigenschaften in das System eingeführt, während die Trichlorsilangruppe zur Anbindung an das Substrat verwendet wird, wobei die Chloridionen als Abgangsgruppen dienen. Um eine ausreichende Hydrophobierung zu gewährleisten, sollte die Bedampfungszeit etwa eine Stunde betragen. Neben einer Hydrophobierung aus der Gasphase kann die Hydrophobierung auch aus Lösung durch Eintauchen in eine' 0,5 %-ige trockene Hexanlösung erfolgen.

Beispiel 7

Beladen eines planaren Druckstempels mit einer Polymersuspension

Die in den oben aufgeführten Beispielen 1 bis 3 beschriebenen Druckstempel werden mit einem Spincoating-Verfahren mit einer Polymersuspension, welche PEDOT:PSS in einer BaytronP®-Formulierung enthält, für 15 Sekunden bei einer Umdrehungsgeschwindigkeit von 2000 Umdrehungen pro Minute belackt. Die überschüssige Polymersuspension wird mit Hilfe eines Silikonabstreichers abgerakelt.

Beispiel 8

Beladen eines planaren Druckstempels mit einer Polymersuspension

Die in den oben aufgeführten Beispielen 1 bis 3 beschriebenen Druckstempel werden in eine Polymersuspension, welche PEDOT:PSS in einer sog. BaytronP®-Formulierung enthält, getaucht. Die überschüssige Polymersuspension wird mit Hilfe eines Silikonabstreichers abgerakelt.

Beispiel 9

Beladen eines flexiblen Druckstempels mit einer Polymersuspension

Die in den oben aufgeführten Beispielen 4 bis 5 beschriebenen Druckstempel werden in eine Polymersuspension, welche PEDOT:PSS in einer sog. BaytronP®-Formulierung enthält, getaucht. Die überschüssige Polymersuspension wird mit Hilfe eines Silikonabstreichers abgerakelt.

Beispiel 10

Übertragung der Polymersuspension auf einen Si/SiO$_2$-Wafer

Einer der in den oben aufgeführten Beispielen 7 bis 8 beschriebenen beladenen Druckstempel wird mit einem Probenhalter derart fixiert, dass die aktive Oberfläche mit der strukturierten Druckseite nach unten orientiert ist. Das zu bedruckende Substrat, beispielsweise ein Siliziumwafer mit einer durch thermische Oxidation gebildeten Siliziumdioxidschicht wird mit einer Polymersuspension für 60 s in Kontakt gebracht. Das in Kontakt bringen des Siliziumsubstrates mit der Polymerlösung erfolgt durch Anheben und Anpressen des Probenhalters, welcher das Substrat durch Ansaugen mittels Vakuum in der vorherbestimmten Position fixiert.

Beispiel 11

Übertragung der Polymersuspension auf Glassubstrate

Eine der in den oben aufgeführten Beispielen 7 bis 8 beschriebenen beladenen Druckstempel wird mit einem Probenhalter derart fixiert, dass die aktive Oberfläche mit der strukturierten Druckseite nach unten orientiert ist. Die zu bedruckende Glasplatte wird anschließend für 60 Sekunden mit einer Polymersuspension in Kontakt gebracht. Das in Kontakt bringen erfolgt durch Anheben und Anpressen eines Probenhalters, welcher das Substrat durch Ansaugen mittels Vakuum fixiert.

Beispiel 12

Übertragung der Polymersuspension auf Polymerfolien

Eine der in den oben aufgeführten Beispielen 7 bis 8 beschriebenen beladenen Druckstempel wird mit einem Probenhalter derartig fixiert, dass die aktive Oberfläche mit der strukturierten Druckseite nach unten orientiert ist. Die zu bedruckende Polymerfolie wird anschließend auf einem planaren Träger fixiert und für 60 Sekunden mit einer Polymerlösung in Kontakt gebracht. Das in Kontakt bringen erfolgt durch Anheben und Anpressen eines Probenhalters, welcher den Substratträger durch Ansaugen mittels Vakuum fixiert.

Beispiel 13

Justiertes Übertragen der Polymersuspension

Die Übertragung der Polymersuspension auf den Druckstempel erfolgt wie in den oben aufgeführten Beispielen 10 bis 12 mit dem Unterschied, dass das zu bedruckende Substrat durch ein vorher durchgeführtes Verfahren mit einer strukturierten Schicht versehen ist. Die Erfassung der unterschiedlichen Orientierungen erfolgt mit Hilfe eines Mikroskops anhand von Justiermarken, die im Layout des jeweiligen Druckstempels vorgesehen sind, in der Weise, dass der Substrathalter eine freie Beweglichkeit aufweist, so dass die Justiermarken durch Bewegung des Substrathalters zur Deckung gebracht werden.

Beispiel 14

Thermische Fixierung der Polymerstrukturen

Substrate, die entsprechend den oben aufgeführten Beispielen 10 bis 14 vorbehandelt wurden, werden von dem Kontakt abgelöst und für eine Minute bei einer Temperatur von 100°C und nachfolgend für 2 Minuten bei einer Temperatur von 120°C auf einer Heizplatte getrocknet.

Beispiel 15

Direktes thermisches Fixieren der Polymerstrukturen

Substrate, die nach den in den oben aufgeführten Beispielen 10 bis 14 vorbehandelt wurden, werden unter Aufrechterhaltung des Kontaktes auf eine Temperatur von 80°C erhitzt. Dabei erfolgt die Wärmeübertragung über einen beheizbaren Substrathalter. Anschließend wird das Substrat für eine Minute bei einer Temperatur von 100°C und nachfolgend für 2 Minuten bei einer Temperatur von 120°C auf einer Heizplatte getrocknet.

Beispiel 16

Drucken mit flexiblen Druckstempeln

Der in dem oben aufgeführten Beispiel 9 beschriebene aus einem Kunststoffzylinder bestehende Druckstempel, wird über eine Polyethylennaphthalat-Folie gerollt, deren Oberfläche zuvor durch Behandlung mit einem Sauerstoffplasma aktiviert, wurde. Zu diesem Zweck wird die Polyethylennaphthalat-Folie von einer zweiten auf eine Temperatur von 70°C beheizten Walze an den walzenförmigen Druckstempel angepresst. Die Laufgeschwindigkeit der Polyethylennaphthalat-Folie beträgt dabei 0,2 cm/s. Anschließend wird der bedruckte Folienabschnitt in einen Ofen überführt und bei einer Temperatur von 120°C für die Dauer von 5 Minuten unter einer Schutzgasatmosphäre getrocknet.

Beispiel 17

Elektrische Charakterisierung bei einem Einlagendruck

Ein nach einem in Beispiel 15 beschriebenen Verfahren bedruckter hochdotierter thermisch oxidierter Siliziumwafer mit einer aufgedruckten Struktur, die dem einfachsten Aufbau eines organischen Feldeffekttransistors (OFET) entspricht, wobei die aufgedruckten PEDOT:PSS-Strukturen den Source- und Drainelementen eines Feldeffekttransistors entsprechen, wird als Substrat bereitgestellt. Auf diese Strukturen wird bei einer Temperatur von 60°C Pentazen als organisches leitfähiges Material aufgedampft. Dabei wurden Transistoren mit einer Ladungsträgerbeweglichkeit von 0,03 cm$^2$/V-s einer Einsatzspannung von 16 V und einer Subeinsatzspannungssteigung von 3,4 V pro Dekade bei einem on/off-Stromverhältnis von 10$^3$ erhalten. Die entsprechende Kennlinie ist in Abbildung 4 dargestellt.

Beispiel 18

Elektrische Charakterisierung bei einem justierten Mehrlagendruck

Ein Glassubstrat wird mit einer Lage PEDOT:PSS wie in Beispiel 15 beschrieben, bedruckt. Diese Strukturen bilden eine die Gateelemente enthaltende Lage eines organischen Feldeffekttransistors. Anschließend wird das Gatedielektrikum bestehend aus 10 % Poly-4-hydroxystyrol, 1 % Vernetzer und 89 % n-Butanol mittels Spincoating aufgebracht. Die Beschichtung mit dem Spincoating-Verfahren wird bei einer Umdrehungsgeschwindigkeit von 2000 Umdrehungen pro Minute für eine Dauer von 30 Sekunden durchgeführt. Nachfolgend erfolgt eine Trocknung bei einer Temperatur von 100°C für eine Minute und abschließend der Vernetzungsprozess für die Dauer von 2 Minuten bei einer Temperatur von 200°C auf einer Heizplatte.
Das Drucken der die Source- und Drainelemente enthaltenden Lagen erfolgt nach dem in Beispiel 13 beschriebenen Verfahren. Auf die derart erzeugten Strukturen wird bei einer Temperatur von 60°C Pentazen als organischer Leiter aufgedampft. Dabei wurden Transistoren mit einer Ladungsträgerbeweglichkeit von 0,05 cm$^2$/V-s, einer Einsatzspannung von 20 V und einer Subeinsatzspannungssteigung von 9 V pro Dekade bei einem on/off-Stromverhältnis von 100 erhalten. Die entsprechende Kennlinie des Transistors ist in Abbildung 5 dargestellt.

Beispiel 19

Mehrfachverwendung der Druckstempel

Die in den oben beschriebenen Beispielen 2, 3 und 5 hergestellten Druckstempel können mehrmals verwendet werden. Dabei ist vor der Wiederverwendung eine Reinigung zur Entfernung der restlichen Polymersuspension durchzuführen. Diese Reinigung erfolgt in einem Aceton als Lösungsmittel enthaltenden Ultraschallbad für die Dauer von zwei Minuten. Anschließend wird der Druckstempel mit Wasser gespült und getrocknet. Eine erneute in Beispiel 6 beschriebene Hydrophobierung der strukturierten Druckseite, ist erst nach jedem fünften Einsatz oder nach mehrwöchigem Liegen notwendig.

Bezugszeichenliste

1      strukturierte Druckseite

2      Trägersubstrat

3      Drucklösung-/suspension

4      Rakelvorrichtung

5      überschüssige Drucklösung-/suspension

6      definiertes Volumen der Drucklösung-/suspension in tieferliegenden Abschnitten der strukturierten Druckseite

7      Substrat

8      Drucklösung-/suspension mit einer definierten Schichtstruktur

9      verfestigte Schichtstruktur

10     hydrophobe Silanschicht

11     flexible Folie

12     Reservoirwanne

13     rotierender Druckstempel

14     Andruckrolle

**Patentansprüche**

**1.** Verfahren zur Herstellung einer organischen Leiterstrecke auf einem Substrat, umfassend zumindest die folgenden Schritte:

- Bereitstellen eines Substrates;
- Bereitstellen eines Druckstempels mit einer darauf befindlichen strukturierten Druckseite, wobei die strukturierte Druckseite erhabene Abschnitte und zwischen den erhabenen Abschnitten angeordnete tiefer liegende Abschnitte aufweist, welche einer abzubildenden Struktur entsprechen;
- Beladen der strukturierten Druckseite mit einer Drucklösung, die zumindest ein leitfähiges organisches Polymer oder eine Vorstufe eines solchen Polymers enthält;
- gegebenenfalls Entfernen überschüssiger Drucklösung von den erhabenen Abschnitten der strukturierten Druckseite, so dass die Drucklösung nur in den tiefer liegenden Abschnitten der strukturierten Druckseite verbleibt;

- gegenseitiges Anordnen und Justieren von Substrat und Druckstempel zueinander, wobei das Substrat auf der strukturierten Druckseite angeordnet wird und in Kontakt bringen der strukturierten Druckseite mit dem Substrat;
- Entfernen des Druckstempels vom Substrat und Obertragen der in der strukturierten Druckseite befindlichen Drucklösung auf das Substrat, wobei die strukturierte Druckseite eine hydrophobe und das Substrat eine hydrophile Grenzfläche aufweisen und die Drucklösung hydrophil ist.

2. Verfahren nach Anspruch 1, wobei die auf das Substrat übertragene Drucklösung durch einen Bakeschritt fixiert wird.

3. Verfahren nach einem der Ansprüche 1 oder 2, wobei die strukturierte Druckseite und/oder der Druckstempel aus einem flexiblen Material bestehen.

4. Verfahren nach einem der Ansprüche 1 bis 3, wobei das Substrat aus einem flexiblen Material besteht.

5. Verfahren nach einem der Ansprüche 1 bis 4, wobei eine Andruckrolle vorgesehen ist, mit welcher das aus einem flexiblen Material bestehende Substrat auf die strukturierte Druckseite gedrückt wird.

6. Verfahren nach einem der Ansprüche 1 bis 5, wobei das Verfahren mehrmals mit gleichen oder verschiedenen Druckseiten mit jeweils gleichen oder verschiedenen Drucklösungen auf das gleiche Substrat angewandt wird.

7. Verfahren nach einem der Ansprüche 1 bis 6, wobei die Leiterstrecke zu einem mikroelektronischen Bauelement ergänzt wird.

8. Verfahren nach einem der Ansprüche 1 bis 7, wobei das mikroelektronische Bauelement ein Feldeffekttransistor ist.

9. Verfahren nach einem der Ansprüche 1 bis 8, wobei das Verfahren mehrmals mit gleichen oder verschiedenen Druckseiten mit jeweils gleichen oder verschiedenen Drucklösungen auf das gleiche Substrat angewandt wird.

10. Verfahren nach Anspruch 9, wobei das mikroelektronische Bauelement ein Feldeffekttransistor ist.


**Claims**

1. Method for fabricating an organic conductor path on a substrate, comprising at least the following steps:

   - provision of a substrate;
   - provision of a printing stamp with a patterned printing side situated thereon, the patterned printing side having elevated sections and deeper sections arranged between the elevated sections, which correspond to a structure to be imaged;
   - loading of the patterned printing side with a printing solution containing at least one conductive organic polymer or a precursor of such a polymer;
   - if appropriate removal of excess printing solution from the elevated sections of the patterned printing side, so that the printing solution remains only in the deeper sections of the patterned printing side;
   - mutual arrangement and alignment of substrate and printing stamp with respect to one another, the substrate being arranged on the patterned printing side, and bringing the patterned printing side into contact with the substrate;
   - removal of the printing stamp from the substrate and transfer of the printing solution situated in the patterned printing side onto the substrate, the patterned printing side having a hydrophobic and the substrate a hydrophilic interface and the printing solution being hydrophilic.

2. Method according to Claim 1, the printing solution transferred onto the substrate being fixed by a baking step.

3. The method according to either of Claims 1 and 2, the patterned printing side and/or the printing stamp comprising a flexible material.

4. The method according to one of Claims 1 to 3, the substrate comprising a flexible material.

5. The method according to one of Claims 1 to 4, a pressure roller being provided, by means of which the substrate comprising a flexible material is pressed onto the patterned printing side.

6. The method according to one of Claims 1 to 5, the method being applied to the same substrate a number of times with identical or different printing sides with respectively identical or different printing solutions.

7. The method according to one of Claims 1 to 6, the conductor path being supplemented to form a microelectronic component.

8. The method according to one of Claims 1 to 7, the microelectronic component being a field-effect transistor.

9. The method according to one of Claims 1 to 8, the method being applied to the same substrate a number of times with identical or different printing sides with respectively identical or different printing solutions.

10. The method according to Claim 9, the microelectronic component being a field-effect transistor.

**Revendications**

1. Procédé de production d'une piste conductrice organique sur un substrat comprenant au moins les stades suivants :

   - on se procure un substrat ;
   - on se procure un poinçon ayant une face d'impression structurée se trouvant dessus, la face d'impression structurée ayant des parties en saillie et, entre les parties en saillie, des parties plus basses qui correspondent à une structure à reproduire ;
   - on charge la face d'impression strcuturée d'une solution d'impression qui contient au moins un polymère organique conducteur ou un précurseur d'un polymère de ce genre ;
   - on élimine, le cas échéant, de la solution d'impression en excès des parties en saillie de la face d'impression structurée de façon à ce que la solution d'impression ne subsiste que dans les parties plus basses de la face d'impression structurée ;
   - on dispose et on ajuste mutuellement le substrat et le poinçon, le substrat étant disposé sur la face d'impression structurée et on met la face d'impression structurée en contact avec le substrat ;
   - on enlève le poinçon du substrat et l'on transfère la solution d'impression se trouvant dans la phase d'impression structurée au substrat, la phase d'impression structurée ayant une surface limité hydrophobe et le substrat une surface limite hydrophile et la solution d'impression étant hydrophile.

2. Procédé suivant la revendication 1, dans lequel on fixe la solution d'impression transmise au substrat par un stade de cuisson.

3. Procédé suivant l'une des revendications 1 ou 2, dans lequel la face d'impression structurée et/ou le poinçon est en une matière souple.

4. Procédé suivant l'une des revendications 1 à 3, dans lequel le substrat est en une matière souple.

5. Procédé suivant l'une des revendications 1 à 4, dans lequel on prévoit un rouleau d'application par lequel le substrat constitué d'une matière souple est poussé sur la face d'impression structurée.

6. Procédé suivant l'une des revendications 1 à 5, dans lequel on utilise le procédé plusieurs fois avec des faces d'impression identiques ou différentes ayant, respectivement, des solutions d'impression identiques ou différentes sur le même substrat.

7. Procédé suivant l'une des revendications 1 à 6, dans lequel on complète la piste conductrice en un composant microélectronique.

8. Procédé suivant l'une des revendications 1 à 7, dans lequel le composant microélectronique est un transistor à effet de champ.

9. Procédé suivant l'une des revendications 1 à 8, dans lequel on utilise le procédé plusieurs fois avec des faces d'impression identiques ou différentes avec des solutions d'impression identiques ou différentes sur le même substrat.

**10.** Procédé suivant la revendication 9, dans lequel le composant microélectronique est un transistor à effet de champ.

FIG. 1A

FIG. 1B

FIG. 1C

FIG. 1D

FIG. 1E

FIG. 1F

FIG. 2A

FIG. 2B

FIG. 3

FIG. 4

FIG. 5